**Europäisches Patentamt**

**European Patent Office**

**Office européen des brevets**

(19)

(11) Veröffentlichungsnummer: **0 208 182**
**B1**

(12) EUROPÄISCHE PATENTSCHRIFT

(45) Veröffentlichungstag der Patentschrift:
08.11.89

(21) Anmeldenummer: **86108422.6**

(22) Anmeldetag: **20.06.86**

(51) Int. Cl.⁴: **H03J 5/24**

(54) **Breitbandiger Sender für kurze elektromagnetische Wellen.**

(30) Priorität: **25.06.85 DE 3522712**

(43) Veröffentlichungstag der Anmeldung:
**14.01.87 Patentblatt 87/3**

(45) Bekanntmachung des Hinweises auf die Patenterteilung:
**08.11.89 Patentblatt 89/45**

(84) Benannte Vertragsstaaten:
**AT BE CH DE FR GB IT LI LU NL**

(56) Entgegenhaltungen:
**EP-A- 0 119 628**
**US-A- 4 165 493**
**US-A- 4 486 722**

**ELECTRONIC COMPONENTS AND APPLICATIONS,
Band 3, Nr. 4, August 1981, Seiten 210-222, Eindhoven,
NL; J. LING: "Wideband linear amplifiers in h.f.
communications"**

(73) Patentinhaber: **Siemens Aktiengesellschaft,
Wittelsbacherplatz 2, D-8000 München 2(DE)**

(72) Erfinder: **Fünfgelder, Helmut, Dipl.-Ing.,
Goethestrasse 28, D-8704 Uffenheim(DE)**
Erfinder: **Ochsmann, Dieter, Siedlerstrasse 2a,
D-8150 Holzkirchen(DE)**
Erfinder: **Zirwas, Johann-Gerhard, Dr. Ing.,
Mittenwaldstrasse 136, D-8038 Gröbenzell(DE)**

## Beschreibung

### Technisches Gebiet

Die Erfindung bezieht sich auf einen in einem breiten Frequenzband durchstimmbaren Sender, insbesondere Kurzwellensender, mit einer zwischen dem Ausgang der Senderendstufe und dem Senderausgang vorgesehenen Filteranordnung, bei der die Filteranordnung aus bestimmten Teilfrequenzbereichen der Senderarbeitsfrequenz zugeordneten Teilfiltern besteht, die zur Unterdrückung unerwünschter Oberwellen der Senderarbeitsfrequenzen alternativ in Abhängigkeit der Senderarbeitsfrequenz ein- und ausgangsseitig über Relais in den Signalweg einschaltbar sind.

### Stand der Technik

Sendereinrichtungen dieser Art sind beispielsweise durch die Literaturstelle "Electronic Components and Applications", Vol. 3, Nr. 4, Aug. 1981, Seiten 210 bis 223, sowie durch die Literaturstelle DE-A 33 10 389 (EP-A 0 119 628) bekannt. Üblicherweise werden bei einem durchstimmbaren Sender im Kurzwellenbereich zwischen 1,5 und 30 MHz eine aus acht Suboktavfiltern bestehende Filteranordnung verwendet. Wegen der hohen Sendeleistung in der Größenordnung von 1 kW finden dabei zum Einschalten der Suboktavfilter in Abhängigkeit der Senderarbeitsfrequenz Relais Anwendung, da sie preiswert und für größere Schaltleistungen geeignet sind. Solche Relais sind jedoch dann nicht geeignet, wenn, wie das zunehmend vom Anwender gefordert wird, ein schneller Frequenzwechsel durchgeführt werden soll, wie er insbesondere bei Anwendung eines Frequenzsprungverfahrens zur Erhöhung der Störresistenz einer Funkverbindung gegeben ist.

Grundsätzlich besteht zwar die Möglichkeit, die Relais durch elektronische Leistungsschalter zu ersetzen, mit denen eine verschleißfreie schnelle Schaltfolge durchgeführt werden kann. Solche elektronischen Leistungsschalter bedingen jedoch durch die hier erforderlichen hohen Schaltströme einen erheblichen technischen Aufwand, der vor allem dann ins Gewicht fällt, wenn viele solcher elektronischen Leistungsschalter, nämlich zwei Leistungsschalter pro Suboktavfilter benötigt werden.

Ein über PIN-Dioden geschaltetes Filternetzwerk wird in der US-A 4 486 722 beschrieben.

### Offenbarung der Erfindung

Der Erfindung liegt die Aufgabe zugrunde, für einen breitbandigen Sender der einleitend beschriebenen Art eine Lösung für die Durchführung eines schnellen Frequenzwechsels anzugeben, der mit einem Minimum an technischem Mehraufwand für elektronische Leistungsschalter auskommt.

Diese Aufgabe wird gemäß der Erfindung durch die im Patentanspruch 1 angegebenen Merkmale gelöst.

Der Erfindung liegt die Erkenntnis zugrunde, daß gerade bei Funkeinrichtungen der für einen Funkbetrieb abhängig von der Tageszeit günstige Frequenzbereich stets nur ein kleinerer Teilbereich des vom breitbandigen durchstimmbaren Funksender erfaßbaren Gesamtfrequenzbereiches ist. Ein schnelles Umschalten zwischen verschiedenen Teilfilterbereichen läßt sich daher unabhängig davon, welche Lage dieser als Frequenzsprungintervall infrage kommende günstige Frequenzbereich innerhalb des vom Sender durchstimmbaren Gesamtfrequenzbereiches einnimmt, stets auf das Umschalten zwischen wenigen Teilfiltern begrenzen. Durch die erfindungsgemäße Aufteilung der Filteranordnung in Teilfiltergruppen werden somit für die Durchführung eines schnellen Frequenzwechsels lediglich elektronische Leistungsschalter für das Umschalten zwischen den verschiedenen Teilfiltergruppen benötigt. Die Lage des Frequenzsprungintervalls innerhalb des vom Sender durchstimmbaren Frequenzbandbereiches wird dabei dadurch bestimmt, welches von den Teilfiltern einer Teilfiltergruppe über sein ein- und ausgangsseitiges Schaltrelais zum Teilfiltergruppenein- und -ausgang durchgeschaltet ist.

Vorteilhaft an diesem Schaltkonzept ist nicht nur die relativ geringe Anzahl von elektronischen Leistungsschaltern, sondern auch die hiermit gegebene Fähigkeit der Modifizierung. Je nachdem, ob der Funksender für einen Frequenzsprungbetrieb befähigt oder nicht befähigt sein soll, können die elektronischen Leistungsschalter ohne Änderung der Filteranordnung und des Schaltgrundkonzeptes zum Einsatz kommen oder entfallen.

Vorteilhafte Ausgestaltungen des Erfindungsgegenstandes entsprechend den Merkmalen nach dem Patentanspruch 1 sind in den weiteren Patentansprüchen 2 bis 5 angegeben.

### Kurze Beschreibung der Zeichnung

In der Zeichnung bedeuten die der näheren Erläuterung der Erfindung dienenden Figuren

Fig. 1 eine übliche Filteranordnung zwischen dem Ausgang der Senderendstufe und dem Senderausgang für einen Kurzwellensender im Bereich zwischen 1,5 und 30 MHz,

Fig. 2 eine in zwei Teilfiltergruppen unterteilte Filteranordnung nach Fig. 1 mit elektronischen Leistungsschaltern zum Umschalten zwischen diesen beiden Teilfiltergruppen,

Fig. 3 eine in drei Teilfiltergruppen unterteilte Filteranordnung nach Fig. 1 mit zwischen diesen Teilfiltergruppen umschaltbaren elektronischen Leistungsschaltern,

Fig. 4 ein die Wirkungsweise der Filteranordnung nach Fig. 3 näher erläuterndes Frequenzdiagramm.

### Bester Weg zur Ausführung der Erfindung

Die übliche Filteranordnung FA, deren Eingang e mit dem Ausgang der Senderendstufe ES und deren Ausgang a mit dem Senderausgang in Verbindung steht, ist für einen Kurzwellensender im Bereich zwischen 1,5 und 30 MHz bemessen. Sie weist acht Teilfilter TP1, TP2, ... TP8 auf. Zweckmäßig sind sie als Kauerparametertiefpässe ausgeführt. Das Teilfilter TP1 ist für den Frequenzbereich 1,5 bis 2,2 MHz vorgesehen und weist eine Grenzfrequenz fg = 2,2 MHz auf. Entsprechend ist das Teilfilter TP2 mit der Grenzfrequenz von 3,2 MHz für den Frequenzbereich 2,2 bis 3,2 MHz, das Teilfilter TP3 mit der Grenzfrequenz 4,2 MHz für den Frequenzbereich 3,2 bis 4,7 MHz und die weiteren Teilfilter TP5, TP6, TP7 und TP8 mit den Grenzfrequenzen 6,7, 9,7, 14, 21 und 3O MHz für die Frequenzbereiche 4,7 bis 6,7 MHz, 6,7 bis 9,7 MHz, 9,7 bis 14 MHz, 14 bis 21 MHz und 21 bis 3O MHz vorgesehen.

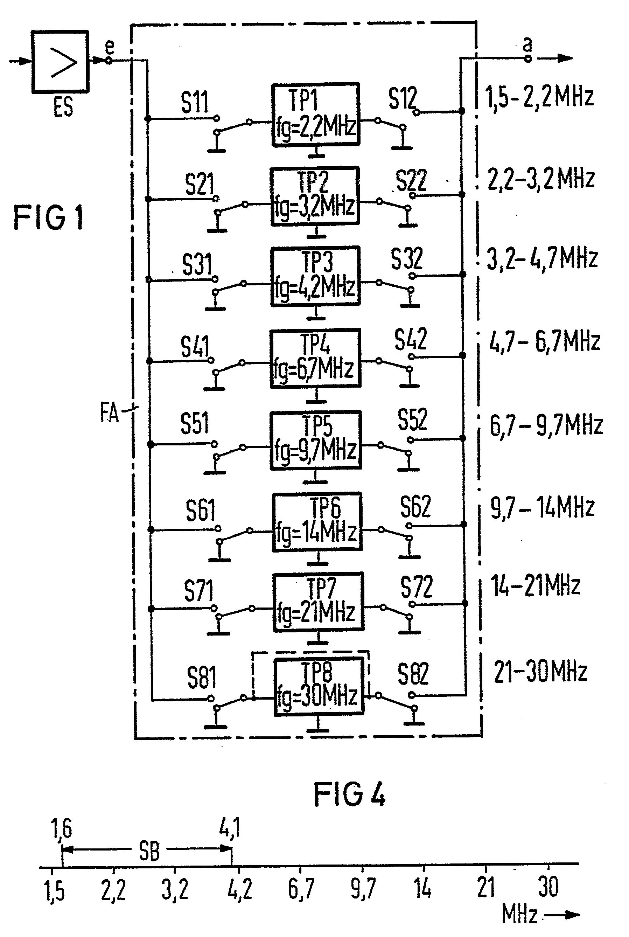

Wie Fig. 1 weiterhin zeigt, werden die Teilfilter TP1, TP2, ... TP8 ein- und ausgangsseitig durch elektrisch gesteuerte Schalter S11, S21, ... S81 bzw. S12, S22, ... S82, die hierbei als Relais ausgeführt sind, alternativ in Abhängigkeit der Senderarbeitsfrequenz in den Signalweg zwischen dem Ausgang der Senderendstufe ES und dem Senderausgang eingeschaltet.

Die Relaisausführung der auf der einen Ausgangsseite der Teilfilter TP1, TP2, ... TP8 vorgesehenen elektrisch steuerbaren Schalter S11, S21, ... S81 bzw. S12, S22, ... S82 können nicht nur hohe Senderleistungen einwandfrei schalten sondern weisen auch die erforderliche Übersprechdämpfung auf. Sie eignen sich jedoch nicht für einen Frequenzsprungbetrieb des Senders, da sie sich hierfür aufgrund ihrer mechanisch bewegten Teile nicht schnell genug schalten lassen und sich darüber hinaus auch sehr schnell abnutzen.

Ein Ersatz sämtlicher Relaisschalter durch elektronische Leistungsschalter, wie sie mit PIN-Dioden realisiert werden können, ist jedoch auch keine geeignete Lösung, da infolge der hohen Schaltströme bei der benötigten großen Anzahl solcher Leistungsschalter der technische Aufwand außerordentlich groß werden würde.

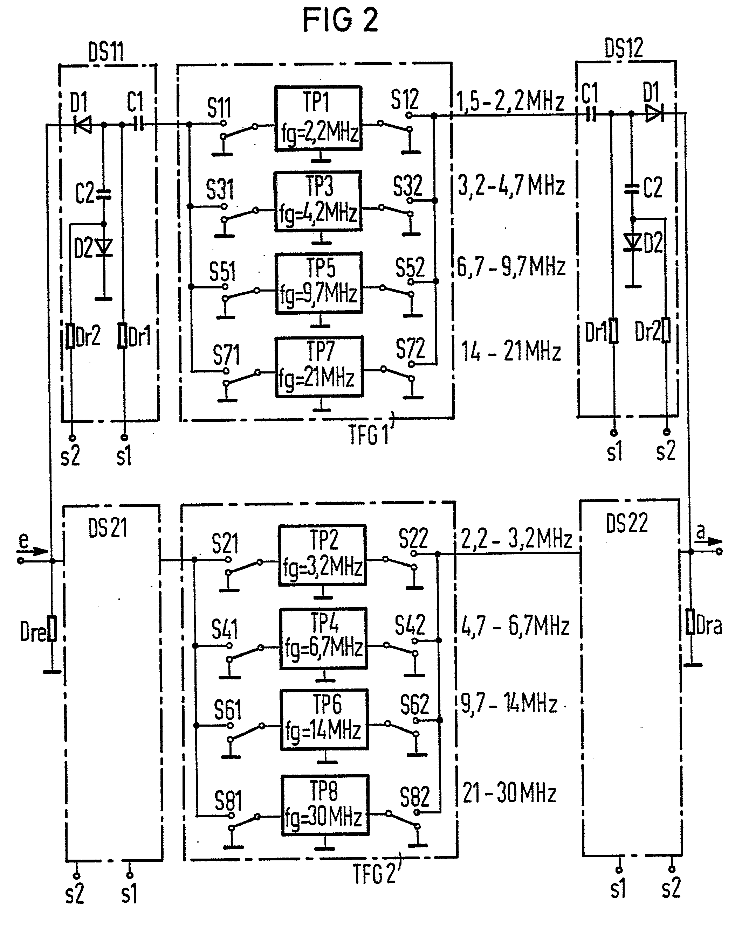

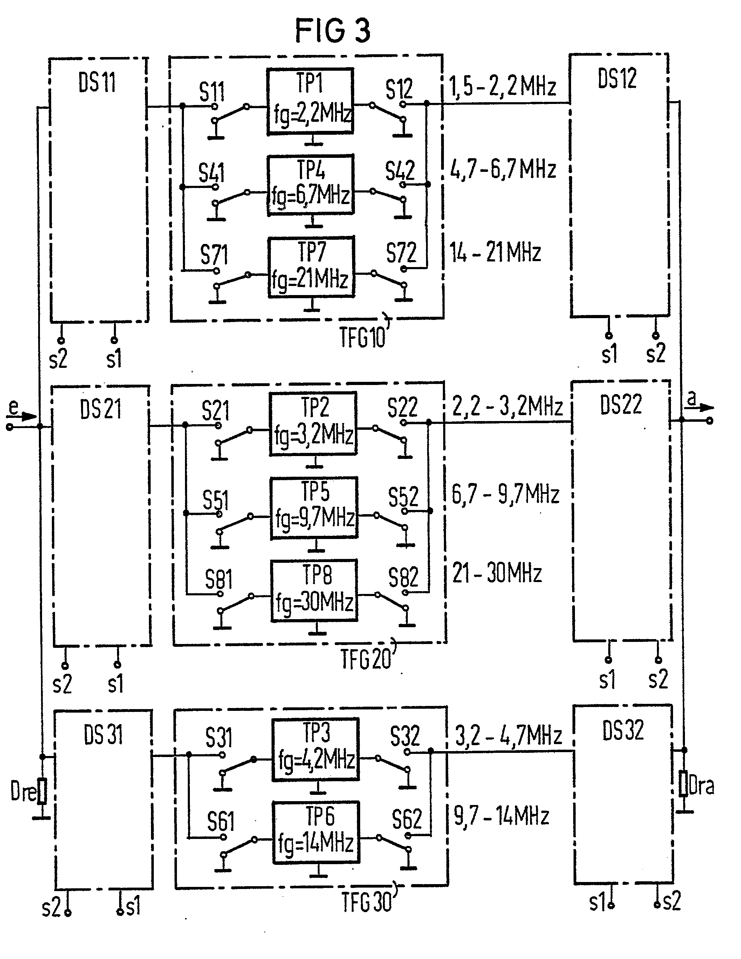

Da, wie bereits ausgeführt worden ist, nur jeweils ein Teilbereich des vom Sender durchstimmbaren Frequenzbereichs für einen Frequenzsprungbetrieb geeignet ist, läßt sich, wie das anhand der Figuren 2 und 3 nunmehr noch näher erläutert werden soll, die für einen solchen Frequenzsprungbetrieb erforderliche Anzahl von elektronischen Leistungsschaltern bei gleichzeitiger Verwendung der bisher üblichen Relaisschalter wesentlich reduzieren.

In Fig. 2 ist die Filteranordnung nach Fig. 1 in zwei Teilfiltergruppen TFG1 und TFG2 unterteilt. Hierbei enthält die Teilfiltergruppe TFG1 die Teilfilter TP1, TP3, TP5 und TP7 einschließlich ihrer ein- und ausgangsseitigen elektrisch gesteuerten Schalter. Die übrigen Teilfilter TP2, TP4, TP6 und TP8 sind einschließlich ihrer ein- und ausgangsseitigen elektrisch gesteuerten Schalter der Teilfiltergruppe TFG2 zugeordnet. Beide Teilfiltergruppen TFG1 und TFG2 stellen jeweils einen Übertragungsweg dar, zwischen denen nun über diesen Teilfiltergruppen TFG1 und TFG2 auf der Ein- und Ausgangsseite zugeordnete Diodenschalter DS11, DS21 bzw. DS12, DS22 sehr rasch umgeschaltet werden kann. Jeder der Diodenschalter DS11, DS21, DS12 und DS22 besteht aus einem Längs- und einem Querzweig. Im Längszweig ist die PIN-Diode D1 in Reihe mit dem Koppelkondensator C1 und im Querzweig die PIN-Diode D2 in Reihe mit dem Koppelkondensator C2 angeordnet. Die für das Schalten der PIN-Dioden D1 und D2 erforderlichen Schaltströme werden über die Anschlüsse s1 und s2 und die Hochfrequenzdrosseln Dr1 und Dr2 jeweils an den Verbindungspunkten zwischen den PIN-Dioden und den ihnen zugeordneten Koppelkondensatoren eingespeist. Weiterhin sind hierzu der Eingang e und der Ausgang a über jeweils eine Hochfrequenzdrossel Dre und Dra gleichstrommäßig mit Bezugspotential verbunden.

Die Aufteilung der Teilfilter in die beiden Teilfiltergruppen TFG1 und TFG2 ist so vorgenommen, daß unabhängig von der Lage der Frequenzsprungintervalls innerhalb des vom Sender durchstimmbaren Gesamtfrequenzbereiches dieses Frequenzsprungintervall stets durch maximal zwei Teilfilter erfaßt wird, von denen jeweils eines der Teilfiltergruppe TFG1 und eines der Teilfiltergruppe TFG2 angehört.

Durch Einschalten dieser Teilfilter über ihre ein- und ausgangsseitigen Relaisschalter kann dann je nach Lage der Sprungfrequenz über die Diodenschalter schnell und verschleißfrei jeweils das zuständige Teilfilter in den Signalweg zwischen dem Eingang e und dem Ausgang a eingeschaltet werden.

Die Unterteilung der Filteranordnung FA nach Fig. 1 in zwei Teilfiltergruppen TFG1 und TFG2 entsprechend Fig. 2 erzwingt an der unteren Frequenzgrenze des vom Sender durchstimmbaren gesamten Frequenzbereiches ein Frequenzsprungintervall, kleiner 2 MHz. Entsprechend der zunehmenden Frequenzbereiche der Suboktavfilter mit zunehmender oberer Grenzfrequenz kann dann das Sprungfrequenzintervall bei höherer Frequenzlage entsprechend breiter gewählt werden. Besteht der Wunsch, unabhängig von der Frequenzlage des Frequenzsprungintervalls über ein Frequenzsprungintervall einer Mindestgröße von 2,5 MHz verfügen zu können, dann kann dies dadurch erreicht werden, daß entsprechend Fig. 3 von einer Unterteilung der Teilfilter der Filteranordnung FA nach Fig. 1 in drei Teilfiltergruppen TFG1O, TFG2O und TFG3O Gebrauch gemacht wird. Die Anzahl der hierbei benötigten Diodenschalter auf der Eingangsseite DS11, DS21 und DS31 und auf der Ausgangsseite DS12, DS22 und DS32 erhöht sich damit gegenüber der Ausführungsform nach Fig. 2 um zwei Diodenschalter.

Im Frequenzdiagramm nach Fig. 4, in dem der vom Sender durchstimmbare Gesamtfrequenzbereich von 1,5 bis 3O MHz aufgezeichnet ist, ist angenommen, daß das eine Bandbreite von 2,5 MHz aufweisende Sprungfrequenzintervall SB seine untere Frequenzgrenze bei 1,6 und seine obere Frequenzgrenze bei 4,1 MHz aufweist. Um hier einen Sprungbetrieb bei gleichzeitiger Unterdrückung unerwünschter Oberwellen der Senderfrequenz ausführen zu können, müssen bei der Teilfiltergruppe TFG1O das Teilfilter TP1 über seine Schalter S11 und S12 der Teilfiltergruppe TFG2O das Teilfilter TP2 über seine Schalter S21 und S22 in der Teilfiltergruppe TFG3O das Teilfilter TP3 über seine Schalter S31 und S32 jeweils mit dem Einund Ausgang der Teilfiltergruppe, der es angehört verbunden sein.

Über die sechs Diodenschalter kann dann schnell und verschleißfrei zwischen den so gebildeten drei Übertragungswegen entsprechend der Augenblickslage der Senderfrequenz innerhalb des Sprungfrequenzintervalls SB umgeschaltet werden.

GewerblicheVerwertbarkeit

Für die Durchführung eines Frequenzsprungbetriebes befähigte Funksender mit ausgangsseitigen Oberwellenfiltern sind für den taktischen Einsatz sowohl im stationären als auch im mobilen Betrieb geeignet.

**Patentansprüche**

1. In einem breiten Frequenzband durchstimmbarer Sender, insbesondere Kurzwellensender, mit einer zwischen dem Ausgang der Senderendstufe und dem Senderausgang vorgesehenen Filteranordnung, bei der die Filteranordnung aus bestimmten Teilfrequenzbereichen der Senderarbeitsfrequenzen zugeordneten Teilfiltern (TP1, TP2, ... TP8) besteht, die zur Unterdrückung unerwünschter Oberwellen der Senderarbeitsfrequenzen alternativ in Abhängigkeit der Senderarbeitsfrequenz ein- und ausgangsseitig über Relais (S11/S12, ... S81/S82) in den Signalweg einschaltbar sind, **dadurch gekennzeichnet, daß** zur Durchführung eines schnellen Frequenzsprungbetriebes innerhalb eines beliebig auswählbaren Teilfrequenzbandes des durchstimmbaren Frequenzbandes die Teilfilter (TP1, TP2 ... TP8) in Reihe mit den ihnen jeweils ein- und ausgangsseitig zugeordneten Relais (S11/S12, S21/S22 ,... S81/S82) in zwei und mehr Teilfiltergruppen (TFG1, 2; TFG 1O, 2O, 3O) mit ein- und ausgangsseitig parallel geschalteten Anschlüssen unterteilt sind, daß ferner jede Teilfiltergruppe ein- und ausgangsseitig über einen elektronischen Gruppenschalter (DS11/DS12, DS21/DS22, DS31/DS32) in den Signalweg einschaltbar ist und daß die Aufteilung der Teilfilter auf die einzelnen Teilfiltergruppen so vorgenommen ist, daß unabhängig von der ausgewählten Lage des für den Frequenzsprungbetrieb vorgegebenen Teilfrequenzbandes (Sprungfrequenzintervall) dieses Sprungfrequenzintervall stets innerhalb eines Teilfrequenzbereiches liegt, der, sofern hierfür mehr als ein Teilfilter in Anspruch genommen werden muß, ausschließlich durch Teilfilter bestimmt ist, die unterschiedlichen Teilfiltergruppen angehören.

2. Sender nach Anspruch 1, **dadurch gekennzeichnet, daß** die Teilfilter (TP1, TP2 ... TP8) Suboktavfilter sind, die in aufsteigender Ordnungszahl entsprechend zunehmender Frequenzen der sie repräsentierenden aneinander grenzen Teilfrequenzbereiche, wechselweise je einer von zwei Teilfiltergruppen (TFG1, TFG2) zugeordnet sind.

3. Sender nach Anspruch 1, **dadurch gekennzeichnet, daß** die Teilfilter (TP1, TP2, ... TP8) Suboktavfilter sind, von denen ausgehend von einer aufsteigenden Ordnungszahl entsprechend zunehmender Frequenzen der sie repräsentierenden aneinander grenzenden Teilfrequenzbereiche, das erste, das vierte und das siebte Teilfilter eine erste

(TFG1O), das zweite, das fünfte und das achte Teilfilter eine zweite (TFG2O) das dritte, das sechste und das neunte eine dritte usw. Teilfiltergruppe bilden.

4. Sender nach Anspruch 3, **dadurch gekennzeichnet, daß** bei insgesamt acht Teilfiltern (TP1, TP2, ... TP8) die dritte Teilfiltergruppe (TFG3O) lediglich vom dritten und sechsten Teilfilter gebildet ist.

5. Sender nach einem der vorhergehenden Ansprüche, **dadurch gekennzeichnet, daß** die elektronischen Gruppenschalter (DS11/DS12, DS21/DS22, DS31/DS32) PIN-Diodenschalter mit einer PIN-Diode (D1) im Längs- und einer PIN-Diode (D2) im Querzweig sind.

**Claims**

1. Transmitter, especially short-wave transmitter, which can be tuned in a wide frequency band and having provided between the output of the transmitter final stage and the transmitter output a filter arrangement, in which the filter arrangement is composed of subfilters (TP1, TP2, ..., TP8) associated with certain component frequency ranges of the transmitter working frequencies, which subfilters can be switched into the signal path alternatively on the input side and on the output side via relays (S11/S12, ..., S81/S82) depending on the transmitter working frequency to suppress undesired harmonics of the transmitter working frequencies, characterized in that for executing rapid frequency hopping within a freely selectable component frequency band of the tunable frequency band, the subfilters (TP1, TP2...TP8) in series with the relays (S11/S12, S21/S22, ...S81/S82) associated with them in each case on the input side and output side are divided into two and more subfilter groups (TFG1, 2; TFG 10, 20, 30) with terminals connected in parallel on the input side and output side, in that furthermore each subfilter group can be switched into the signal path on the input side and output side via an electronic group switch (DS11/DS12, DS21/DS22, DS31/DS32), and in that the allocation of the subfilters to the individual subfilter groups is made in such a way that, regardless of the selected position of the component frequency band (frequency hopping interval) specified for frequency hopping, this frequency hopping interval always remains within a component frequency range which, inasmuch as it is necessary to employ more than one subfilter for this purpose, is solely determined by subfilters belonging to different subfilter groups.

2. Transmitter according to Claim 1, characterized in that the subfilters (TP1, TP2... TP8) are suboctave filters associated in ascending order, in accordance with increasing frequencies of adjoining component frequency ranges representing them, alternately with one of two subfilter groups (TFG1, TFG2) in each case.

3. Transmitter according to Claim 1, characterized in that the subfilters (TP1, TP2, ... TP8) are suboctave filters, of which, starting from an ascending order in accordance with increasing frequencies of the adjoining component frequency ranges representing them, the first, the fourth and the seventh subfilter form a first subfilter group (TFG10), the second, the fifth and the eighth subfilter form a second subfilter group (TFG20), and the third, the sixth and the ninth form a third subfilter group etc.

4. Transmitter according to Claim 3, characterized in that with a total of eight subfilters (TP1, TP2, ... TP8), the third subfilter group (TFG30) is formed only by the third and sixth subfilter.

5. Transmitter according to one of the preceding claims, characterized in that the electronic group switches (DS11/DS12, DS21/DS22, DS31/DS32) are p-i-n diode switches with one p-i-n diode (D1) in the serial arm and one p-i-n diode (D2) in the shunt arm.

**Revendications**

1. Emetteur dont la fréquence est variable dans une large bande de fréquence, en particulier émetteur à ondes courtes, comprenant un dispositif de filtrage prévu entre la sortie de l'étage final de l'émetteur et la sortie de l'émetteur, dans lequel le dispositif de filtrage est formé de filtres élémentaires (TP1, TP2, ..., TP8) coordonnés à des gammes de fréquences partielles déterminées de la fréquence de fonctionnement de l'émetteur, filtres élémentaires qui, pour la suppression d'harmoniques indésirés des fréquences de fonctionnement de l'émetteur, peuvent être interposés alternativement dans le trajet du signal par leurs entrées et sorties, au moyen de relais (S11/S12, ..., S81/S82) suivant la fréquence de fonctionnement de l'émetteur, caractérisé en ce que, pour réaliser un fonctionnement à saut de fréquences rapide à l'intérieur d'une bande de fréquence partielle pouvant être choisie librement de la bande de fréquence, les filtres élémentaires (TP1, TP2 ...TP8) en série avec les relais (S11/S12, S21/S22, ... S81/S82) qui leur sont coordonnés à l'entrée et à la sortie, sont divisés en deux ou davantage de groupes de filtres élémentaires (TFG1, 2; TFG 10, 20, 30) avec des connexions montées en parallèle à l'entrée et à la sortie, que chaque groupe de filtres élémentaires peut être interposé, en outre, dans le chemin du signal par un interrupteur électronique de groupe à l'entrée et à la sortie (DS11/DS12, DS21/DS22, DS31/DS32) et que la répartition des filtres élémentaires sur les différents groupes est réalisée de manière qu'indépendamment de la position choisie de la bande de fréquence partielle prédéterminée pour le fonctionnement à saut de fréquence (intervalle des fréquences de saut), cet intervalle de fréquences de saut se trouve toujours à l'intérieur d'une gamme de fréquences partielle qui, dans la mesure où cela demande plus d'un filtre élémentaire, soit déterminé exclusivement par des filtres élémentaires appartenant à des groupes différents.

2. Emetteur selon la revendication 1, caractérisé en ce que les filtres élémentaires (TP1, TP2 ...TP8) sont des filtres suboctaves qui sont coordonnés alternativement à l'un de deux groupes de filtres élémentaires (TFG1, TFG2) dans des fréquences augmentant selon un nombre ordinal croissant des gammes de fréquences partielles adjacentes qu'elles représentent.

3. Emetteur selon la revendication 1, caractérisé en ce que les filtres partiels (TP1, TP2, ...TP8) sont des filtres suboctaves dont, partant de fréquences augmentant selon un nombre ordinal croissant des gammes de fréquences partielles adjacentes qu'elles représentent, les premier, quatrième et septième filtres élémentaires forment un premier groupe de filtres partiels (TFG10), les deuxième, cinquième et huitième filtres élémentaires forment un deuxième groupe de filtres élémentaires (TFG20), les troisième, sixième et neuvième filtres élémentaires forment un troisième groupe de filtres élémentaires, et ainsi de suite.

4. Emetteur selon la revendication 3, caractérisé en ce que, s'il y a huit filtres élémentaires en tout (TP1, TP2 ...TP8), le troisième groupe de filtres élémentaires (TFG30) est formé seulement par le troisième et le sixième filtre élémentaire.

5. Emetteur selon une des revendications précédentes, caractérisé en ce que les interrupteurs électroniques de groupes (DS11/DS12, DS21/DS22, DS31/DS32) sont des interrupteurs à diodes P.I.N., comprenant une diode P.I.N. (D1) dans la branche longitudinale et une diode P.I.N. (D2) dans la branche transversale.

## FIG 1

| | | |
|---|---|---|
| S11 | TP1 fg=2,2MHz | S12 — 1,5 – 2,2MHz |
| S21 | TP2 fg=3,2MHz | S22 — 2,2 – 3,2MHz |
| S31 | TP3 fg=4,2MHz | S32 — 3,2 – 4,7MHz |
| S41 | TP4 fg=6,7MHz | S42 — 4,7 – 6,7MHz |
| S51 | TP5 fg=9,7MHz | S52 — 6,7 – 9,7MHz |
| S61 | TP6 fg=14MHz | S62 — 9,7 – 14MHz |
| S71 | TP7 fg=21MHz | S72 — 14 – 21MHz |
| S81 | TP8 fg=30MHz | S82 — 21 – 30MHz |

## FIG 4

# FIG 2

# FIG 3